Europäisches Patentamt

European Patent Office

Office européen des brevets

(11) Veröffentlichungsnummer: **0 469 185 A1**

(12) **EUROPÄISCHE PATENTANMELDUNG**

(21) Anmeldenummer: **90123226.4**

(22) Anmeldetag: **04.12.90**

(51) Int. Cl.5: **H05K 7/14**

(30) Priorität: **30.07.90 DE 9011202 U**

(43) Veröffentlichungstag der Anmeldung:
**05.02.92 Patentblatt 92/06**

(84) Benannte Vertragsstaaten:
**BE DE FR GB**

(71) Anmelder: **SIEMENS AKTIENGESELLSCHAFT**
**Wittelsbacherplatz 2**
**W-8000 München 2(DE)**

(72) Erfinder: **Betzler, Hans Ludwig, Dipl.-Ing. (FH)**
**Allgäuerstrasse 57**
**W-8000 München 71(DE)**
Erfinder: **Ouerengässer, Manfred**
**Nockherstrasse 36a**
**W-8000 München 90(DE)**

(54) **Aufnahme für eine aus einem Leiterplattenpaket bestehende elektrische Baugruppe.**

(57) Das im Querschnitt U-förmige, wannenartige Metallgehäuse (1) zur Aufnahme eines Leiterplattenpaketes besteht aus einer punktgeschweißten Blechkonstruktion mit L- und U-förmigem Blechteil (2,5), inneren Auflagewinkeln (14,15,16) für die Schraubbefestigung der Metallgrundplatte (22) des Leiterplattenpaketes und äußeren Schienen (20) zur Schraubbefestigung der Aufnahme in einem Gerät. Die Erfindung ist für Leiterplattenpakete geeignet.

## FIG 1

Die Erfindung betrifft eine Aufnahme für eine aus einem Leiterplattenpaket mit Grundplatte bestehende elektrische Baugruppe, mit einem im Querschnitt U-förmigen, wannenartig ausgebildeten metallenen Gehäuse.

Elektrische Geräte, insbesondere der Nachrichtentechnik, enthalten häufig aus mehreren parallelen Leiterplatten bestehende Baugruppen. Derartige Baugruppen weisen als Träger für die Leiterplatten eine Grundplatte auf, wobei die parallele Montage und die Positionierung der Leiterplatten über Abstandselemente erfolgt. Baugruppen müssen in elektrischen Geräten häufig mechanisch getrennt und elektrisch abgeschirmt von anderen Baugruppen untergebracht werden. Hierzu verwendet man oft im Querschnitt U-förmige, wannenartig ausgebildete, metallene Gehäuse, in welche die zu einer Baugruppe gehörenden Leiterplatten einzeln eingeschoben werden.

Der Erfindung liegt die Aufgabe zugrunde, eine Aufnahme für eine aus einem Leiterplattenpaket bestehende Baugruppe zu schaffen, die einfach herstellbar und in geeigneter Weise auch zu ihrer eigenen Unterbringung in einem elektrischen Gerät ausgebildet ist.

Diese Aufgabe wird bei einer Aufnahme der eingangs genannten Art gemäß der Erfindung dadurch gelöst, daß das Gehäuse aus einer punktgeschweißten Blechkonstruktion besteht, daß auf der Innenfläche der Gehäuseseitenwände auf gleicher Höhe jeweils ein aus Blech bestehender Auflagewinkel mit Gewindeeinpreßmuttern zur schraubbaren Befestigung der Grundplatte des Leiterplattenpaketes angepunktet ist, und daß an der Außenfläche von drei Gehäuseseitenwänden mit unverlierbaren Schrauben ausgebildete, auf gleicher Höhe angeordnete Schienen zur Halterung der Aufnahme in einem Gerät befestigt sind.

Eine derartige Aufnahme ist mit einfachen Blechteilen herstellbar. Die inneren, auf gleicher Höhe angeordneten Auflagewinkel bieten einen definierten Anschlag beim Einführen einer Baugruppe in die Aufnahme und eine einfache Befestigungsmöglichkeit. Die äußeren Schienen ermöglichen eine schnelle Befestigung der Aufnahme in einem elektrischen Gerät.

Vorteilhafte Ausgestaltungen des Gegenstandes des Anspruchs 1 sind in den Unteransprüchen angegeben.

Ein Ausführungsbeispiel einer erfindungsgemäßen Aufnahme ist im folgenden anhand der Zeichnung näher beschrieben.

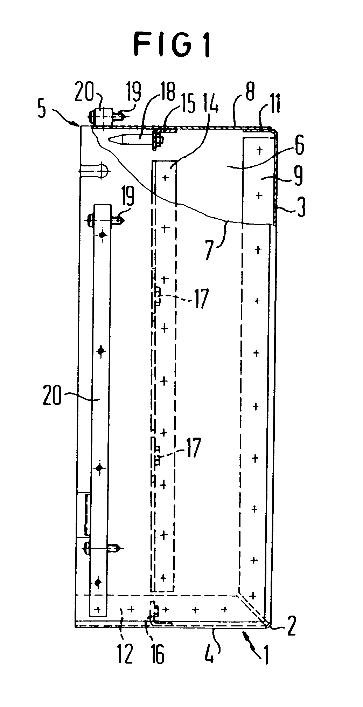

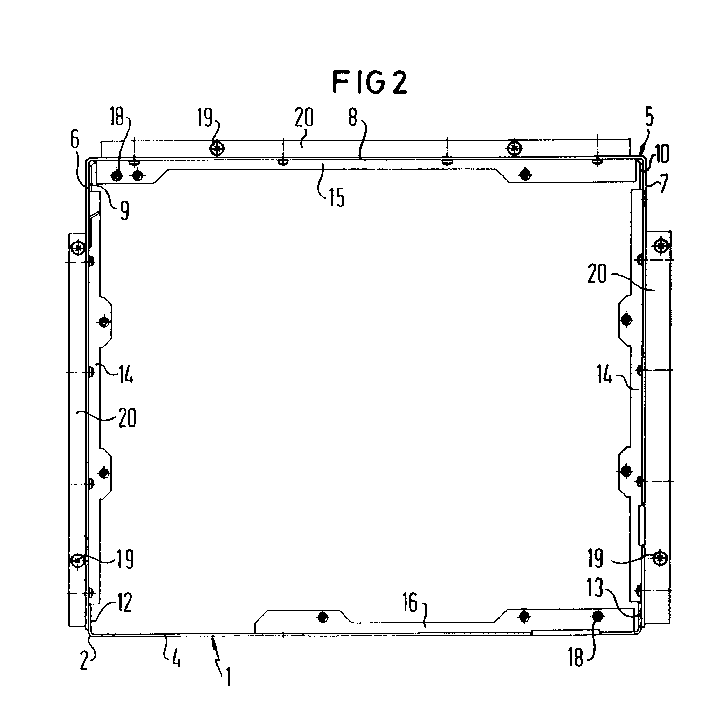

Die Figuren 1 und 2 zeigen eine Aufnahme in Seiten- bzw. in Vorderansicht ohne elektrische Baugruppe,
die Figuren 3 und 4 entsprechende Ansichten der Aufnahme mit elektrischer Baugruppe.

Die Aufnahme besteht aus einem im Querschnitt U-förmigen, wannenartig ausgebildeten Gehäuse 1 aus einer punktgeschweißten Blechkonstruktion. Das Gehäuse 1 ist hier aus einem L-förmigen Blechteil 2 und einem U-förmigen Blechteil 5 zusammengesetzt, wobei das L-förmige Blechteil 2 z.B. die Gehäuserückwand 3 und eine Gehäuseseitenwand, z.B. den Gehäuseboden 4, und das U-förmige Blechteil 5 die übrigen drei Gehäuseseitenwände 6,7 und 8 bildet. Die beiden Blechteile 2 und 5 sind durch Punktschweißen miteinander verbunden. Hierzu ist das L-förmige Blechteil 2 mit um 90° abgewinkelten Randleisten 9 bis 13 ausgebildet, wobei der lange, die Gehäuserückwand 3 bildende Schenkel des L-förmigen Blechteiles 2 zwei seitliche Randleisten 9 und 10 und an der Oberkante eine stirnseitige Randleiste 11 aufweist und der kurze, den Gehäuseboden 4 bildende Schenkel des L-förmigen Blechteiles 2 mit zwei seitlichen Randleisten 12,13 ausgebildet ist.

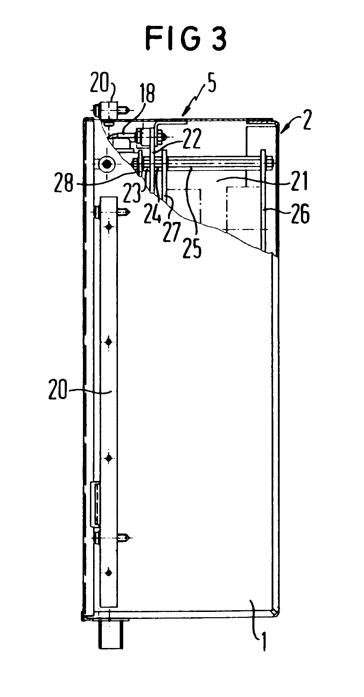

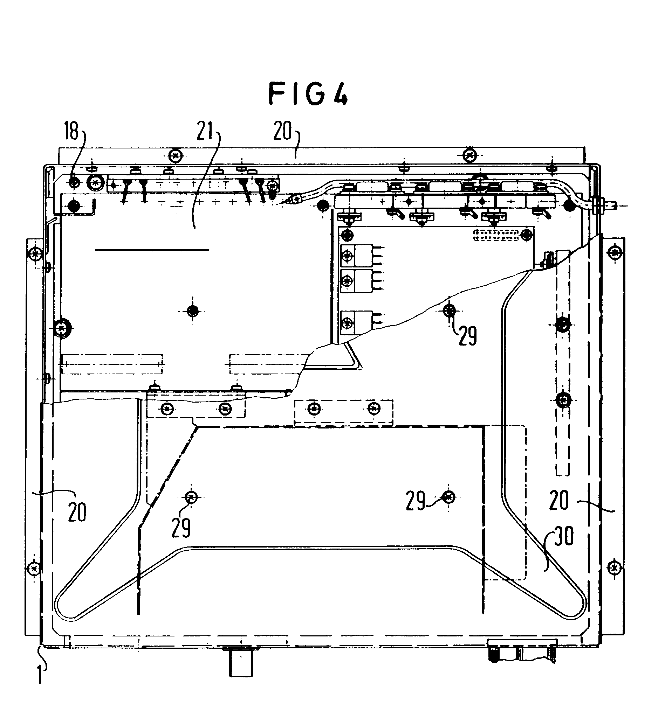

Zur Aufnahme einer elektrischen Baugruppe 21 (Fig.3,4), welche aus einem Leiterplattenpaket mit einer metallenen Grundplatte 22 und beiderseits an dieser Grundplatte mittels Abstandselementen 23,24,25 gehaltenen Leiterplatten 26,27 und 28 besteht, ist auf der Innenfläche der Gehäuseseitenwände 4,6,7 und 8 auf gleicher Höhe jeweils ein aus Blech bestehender, mit Gewindeeinpreßmuttern 17 ausgebildeter Auflagewinkel 14,15, 16 angepunktet, an dem die Grundplatte 22 des Leiterplattenpaketes schraubbar befestigt ist. Diese Auflagewinkel bilden einen definierten Anschlag beim Einführen der Baugruppe 21 in die Aufnahme. Zur Erleichterung der Einführung sind zwei einander gegenüberliegende Auflagewinkel, hier die Auflagewinkel 15 und 16, derart mit jeweils einem Führungsbolzen 18 für die Grundplatte 22 des Leiterplattenpaketes versehen, daß die beiden Führungsbolzen 18 einander diagonal gegenüberliegen und unterschiedliche Seitenabstände zu den Gehäuseseitenwänden 6 und 7 haben. Diese in entsprechende Bohrungen der Grundplatte hineinragenden Führungsbolzen gewährleisten einen lagerichtigen und problemlosen Einbau der Baugruppe. Nach dem Einbau der Baugruppe in das Gehäuse 1 sind die Leiterplatten 26,27 mechanisch getrennt und elektrisch abgeschirmt von der Leiterplatte 28 in einem eigenen Baugruppenraum angeordnet. An der Leiterplatte 28 werden nun die elektrischen Versorgungsleitungen angesteckt. Die gesamte Baugruppe und das Gehäuse ist dann mit Hilfe von unverlierbaren Befestigungsschrauben 29 mit einem durch Prägungen versteiften Blechdeckel 30 verschlossen.

Zur Halterung der Aufnahme in einem Gerät sind an der Außenfläche von drei Gehäuseseitenwänden, hier an der oberen Gehäuseseitenwand 8 und den beiden seitlichen Gehäusewänden 6,7, also an dem U-förmigen Blechteil 5, mit unverlierbaren Schrauben 19 ausgebildete Schienen 20 auf gleicher Höhe angeordnet und schraubbar an den Gehäuseseitenwänden befestigt.

**Patentansprüche**

1. Aufnahme für eine aus einem Leiterplattenpaket mit Grundplatte bestehende elektrische Baugruppe, mit einem im Querschnitt U-förmigen, wannenartig ausgebildeten metallenen Gehäuse,
   **dadurch gekennzeichnet**, daß das Gehäuse (1) aus einer punktgeschweißten Blechkonstruktion besteht, daß auf der Innenfläche der Gehäuseseitenwände (4,6,7,8) auf gleicher Höhe jeweils ein aus Blech bestehender Auflagewinkel (14,15,16) mit Gewindeeinpreßmuttern (17) zur schraubbaren Befestigung der Grundplatte (22) des Leiterplattenpaketes angepunktet ist, und
   daß an der Außenfläche von drei Gehäuseseitenwänden (6,7,8) mit unverlierbaren Schrauben (19) ausgebildete, auf gleicher Höhe angeordnete Schienen (20) zur Halterung der Aufnahme in einem Gerät befestigt sind.

2. Aufnahme nach Anspruch 1,
   **dadurch gekennzeichnet**, daß das Gehäuse (1) aus einem L-förmigen, die Gehäuserückwand (3) und eine Gehäuseseitenwand (4) bildenden Blechteil (2) und aus einem U-förmigen, die übrigen drei Gehäuseseitenwände (6,7,8) bildenden Blechteil (5) besteht.

3. Aufnahme nach Anspruch 2,
   **dadurch gekennzeichnet**, daß das L-förmige Blechteil (2) zur Punktschweißverbindung mit dem U-förmigen Blechteil (5) mit um 90° abgewinkelten Randleisten (9 bis 13) ausgebildet ist.

4. Aufnahme nach Anspruch 2 oder 3,
   **dadurch gekennzeichnet**, daß die Schienen (20) an dem U-förmigen Blechteil (5) angeordnet sind.

5. Aufnahme nach einem der Ansprüche 1 bis 4,
   **dadurch gekennzeichnet**, daß zwei einander gegenüberliegende Auflagewinkel (15,16) derart mit jeweils einem Führungsbolzen (18) für die Grundplatte (22) des Leiterplattenpaketes versehen sind, daß die beiden Führungsbolzen (18) einander diagonal gegenüberstehen.

6. Aufnahme nach einem der vorhergehenden Ansprüche,
   **dadurch gekennzeichnet**, daß die Schienen (20) an der oberen und den beiden seitlichen Gehäuseseitenwänden (8 bzw. 6,7) angeordnet und schraubbar befestigt sind.

# FIG 1

# FIG 2

# FIG 3

# FIG 4

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | DE-U-8 505 220 (BROWN BOVERY & CIE AG)<br>* Seite 3, Zeile 25 - Seite 4, Zeile 2; Abbildung 1 *<br>--- | 1 | H05K7/14 |
| A | US-A-3 603 845 (BEERS)<br>* Spalte 4, Zeile 51 - Zeile 68 *<br>* Spalte 5, Zeile 4 - Zeile 21; Abbildungen 2,4 *<br>--- | 1 | |
| A | DE-U-8 902 820 (RITTAL-WERK RUDOLF LOH GMBH)<br>* Seite 4, Zeile 17 - Zeile 23; Abbildung 1 *<br>----- | 1 | |
| | | | **RECHERCHIERTE SACHGEBIETE (Int. Cl.5)**<br><br>H05K |

Der vorliegende Recherchenbericht wurde für alle Patentansprüche erstellt

| Recherchenort | Abschlußdatum der Recherche | Prüfer |
|---|---|---|
| DEN HAAG | 22 NOVEMBER 1991 | RUBENOWITZ A. |